# EUROPEAN PATENT APPLICATION

(11) **EP 0 973 237 A1**
(43) Date of publication of application: **19.01.2000**
(21) Application number: 98901070.7
(22) Date of filing: 30.01.1998
(51) Int. Cl.: H01S 3/18, H01S 3/043

(54) **SEMICONDUCTOR LASER DEVICE**

(71) Applicant: MITSUBISHI DENKI KABUSHIKI KAISHA, Tokyo 100 (JP)
(72) Inventor: SATO, Shinji, Mitsubishi Denki Kabushiki Kaisha, Tokyo 100 (JP); USUI, Akaru, Mitsubishi Denki Kabushiki Kaisha, Tokyo 100 (JP); FUKUMURA, Kyouko, Mitsubishi Denki Kabushiki K., Tokyo 100 (JP)
(74) Representative: HOFFMANN - EITLE
(86) International application number: JP9800402
(87) International publication number: WO9939412

(57) **Abstract**

A semiconductor laser apparatus includes a semiconductor laser array (1); a plate-shaped submount (2) having a coefficient of thermal expansion nearly equal to that of the semiconductor laser array and having high thermal conductivity; and a heat sink (9) having a cooling water path (4) through which cooling water is passed such that the cooling water comes into direct contact with said submount thereby cooling said submount, whereby improved cooling efficiency is achieved. A semiconductor laser apparatus according to another aspect includes a plurality of semiconductor laser modules disposed in parallel, each semiconductor laser module including a semiconductor laser array (1), a submount (2), and a heat sink (3), wherein cooling water is supplied in parallel to the respective modules so that the respective modules are equally cooled.

## Description

### Technical Field

The present invention relates to a semiconductor laser apparatus, and more particularly to a cooling mechanism therefor.

### Background Art

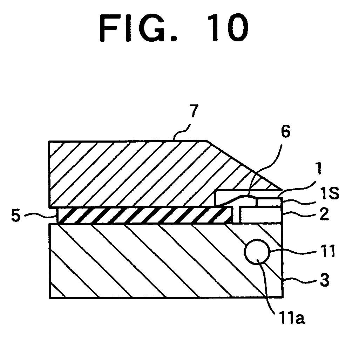

Fig. 10 illustrates a cross-sectional view of a conventional semiconductor laser apparatus. Reference numeral 1 denotes a semiconductor laser array, 2 denotes a submount, 3 denotes a heat sink, 11 denotes a cooling pipe disposed in the heat sink 3, 7 denotes a cover for protecting the semiconductor laser array 1, 5 denotes an insulating plate for maintaining electric insulation between the heat sink 3 and the cover 7, and 6 denotes a lead wire for supplying an electric current to the semiconductor laser array 1. 1S denotes a laser emitting surface of the semiconductor laser array 1.

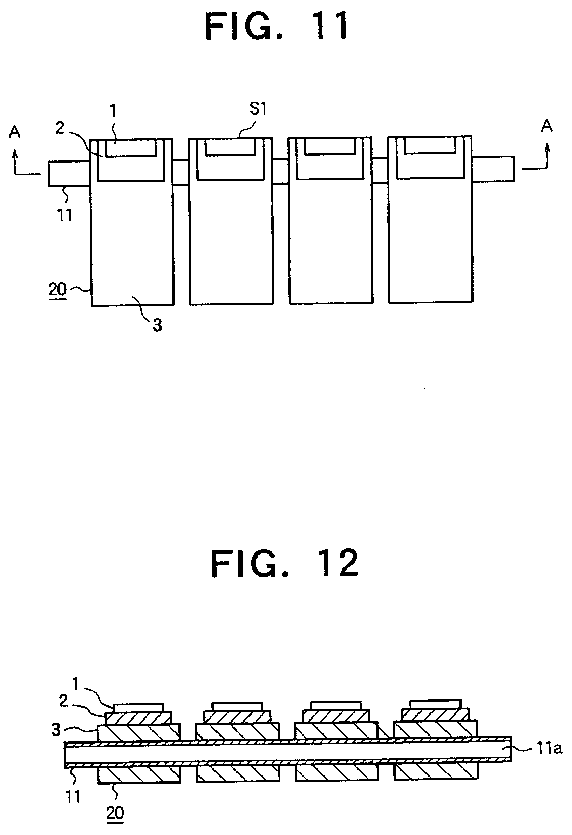

Fig. 11 is a top view of a conventional semiconductor laser apparatus including a plurality of semiconductor laser modules disposed in parallel. Fig. 12 is a cross-sectional view taken along line A-A of Fig. 11. In these figures, equivalent or similar parts to those in Fig. 10 are denoted by similar reference numerals. The cover 7 is not shown in Figs. 11 and 12. Each of the plurality of semiconductor laser modules 20 includes a semiconductor laser array 1, a submount 2, and a heat sink 3, and a cooling pipe 11 is passed through the heat sinks 3, from one to another, of the respective semiconductor laser modules 20.

The cooling mechanism of the semiconductor laser apparatus is described below. The semiconductor laser array 1 includes a plurality of semiconductor laser devices for outputting a laser beam wherein the plurality of semiconductor laser devices are arranged in a linear line. The semiconductor laser array 1 may be produced on a semiconductor substrate in the form of a rectangular plate, via semiconductor production processes such as a lithography process.

A current is supplied to the semiconductor laser array 1 through upper and lower surfaces of a rectangular plate serving as electrodes. In the example shown in Fig. 10, the current flows from the heat sink 3 toward the cover 7 via the submount 2, the semiconductor laser array 1, and the lead wire 6.

When the semiconductor laser array 1 is excited by the current, a laser beam is emitted from the laser beam emitting surface 1s. However, some excitation energy which does not contribute to emission of the laser beam is wasted as heat, which results in an increase in the temperature of the semiconductor laser array 1. When the increase in the temperature of the semiconductor laser array 1 is relatively small, the increase in the temperature results in a change in the energy band structure of the semiconductor laser and thus exerts an influence on the output wavelength. When the increase in the temperature is great, an end face of the semiconductor laser array 1 is melted and the semiconductor laser array 1 is broken.

To avoid the undesirable effects described above, it is required to cool the semiconductor laser array 1. For high-power semiconductor laser apparatuses, in particular for several W (watt) class apparatuses, air-cooling is not enough in cooling ability and it is required to employ water-cooling. In water-cooling, the heat sink 3 is generally made of a copper-based material which has a high thermal conductivity and which is easy to produce and, besides, inexpensive. The cooling pipe 11 is disposed in the heat sink 3 so that the heat sink 3 is cooled by water passed through the cooling pipe 11.

However, because the copper-based material has a different coefficient of thermal expansion from that of semiconductor laser material such as GaAs or InGaAs, if the semiconductor laser array 1 is connected directly to the copper-based heat sink 3 for the purpose of cooling, the difference in thermal expansion can cause the semiconductor laser array 1 to be broken. To avoid the above problem, a submount 2, having a coefficient of thermal expansion nearly equal to that of the semiconductor laser material and having large thermal conductivity, is disposed between the semiconductor laser array 1 and the heat sink 3 so as to ease the stress caused by the difference in coefficient of thermal expansion, which would otherwise be directly exerted from the heat sink 3 to the semiconductor laser array 1.

Figs. 11 and 12 illustrates a technique of cooling a plurality of semiconductor laser modules 20 disposed side by side. The cooling pipes 11 of the heat sinks 3 of the respective semiconductor laser modules 20 are connected in series and water is passed into the cooling pipes from one end.

However, there is a large thermal resistance between the semiconductor laser array 1 and the cooling water, because the submount 2 is disposed between the semiconductor laser array 1 and the heat sink 3 to reduce the thermal stress and because there are adhesive surfaces between respective components. As a result, the efficiency of cooling the semiconductor laser array 1 is low, and thus even if cooling water at a constant temperature is supplied, the temperature of the semiconductor laser array 1 increases with the exciting current. The increase in the temperature can exert an influence on the energy band structure of the semiconductor laser and thus can change the output wavelength. If the temperature increases further, the end face of the semiconductor laser array will be melted and the semiconductor laser array will be thermally destroyed.

In the conventional system for cooling the semiconductor laser apparatus, as described above, the large thermal resistance between the semiconductor laser array and the cooling water causes the problem that even if the temperature of the cooling water is controlled at a particular value, it is difficult to control the temperature of the semiconductor laser array and thus a drift of the output wavelength can occur and the output power is limited.

When a plurality of semiconductor laser modules are disposed in parallel and the cooling water pipes of the heat sinks of the respective semiconductor laser modules are connected in series so as to cool all heat sinks, a large pressure loss occurs and thus it is impossible to supply a sufficiently large amount of water.

In the cooling technique by means of serial connection, semiconductor laser modules at downstream locations are cooled by water whose temperature has increased when cooling semiconductor laser modules at upstream locations. This results in a reduction in the cooling effect for the semiconductor laser modules at downstream locations and thus there can be differences in output wavelength between the semiconductor laser modules at upstream locations and those at downstream locations.

It is a general object of the present invention to solve the above problems. More specifically, it is an object of the present invention to provide a technique of reducing the thermal resistance between a semiconductor laser array and cooling water thereby providing a semiconductor laser apparatus capable of emitting a laser beam with a stabilized wavelength and with an increased maximum output power.

It is another object of the present invention to provide a semiconductor laser apparatus including a plurality of semiconductor laser modules disposed side by side which are efficiently and uniformly cooled by a cooling mechanism.

### Disclosure of Invention

According to an aspect of the invention, there is provided a semiconductor laser apparatus including: a semiconductor laser array; a plate-shaped submount having a coefficient of thermal expansion nearly equal to that of the semiconductor laser array and having high thermal conductivity; and a heat sink having a cooling water path through which cooling water is passed such that the cooling water comes into direct contact with the submount thereby cooling the submount.

In this semiconductor laser apparatus according to the invention, the cooling water path of the heat sink is preferably formed in the shape of a groove.

In this semiconductor laser apparatus according to the invention, the submount and the heat sink are disposed at both side of the semiconductor laser array so that the semiconductor laser array is cooled from both sides.

In the semiconductor laser apparatus according to the present invention, the apparatus may further include a mounting base on which laser arrays, submounts and heat sinks are mounted all together, wherein the mounting base includes a cooling water supply pipe connected to one end of the cooling water path of each heat sink so as to supply cooling water and also includes a cooling water drain pipe connected to the other end of the cooling water path so as to drain the cooling water whereby the cooling water is supplied and drained in parallel to and from the respective heat sinks.

In the semiconductor laser apparatus, a plurality of said semiconductor laser arrays may be disposed in a stacked fashion, two submounts may be bonded to both sides, respectively, of each said semiconductor laser array, and there may be provided heat sinks each having a cooling water path which is formed between respective adjacent submounts or on the outer surface of submounts located at both ends such that cooling water flowing through the cooling water path comes in direct contact with a submount located at one side or two submounts located at both sides.

This semiconductor laser apparatus may further include a mounting base on which laser arrays, submounts and heat sinks are mounted all together, wherein the mounting base includes a cooling water supply pipe connected to one end of the cooling also includes a cooling water drain pipe connected to the other end of the cooling water path so as to drain the cooling water whereby the cooling water is supplied and drained in parallel to and from the respective heat sinks.

According to another aspect of the present invention, there is provided a semiconductor laser apparatus including a plurality of semiconductor laser modules each including a semiconductor laser array; a plate-shaped submount having a coefficient of thermal expansion nearly equal to that of the semiconductor laser array and having high thermal conductivity; and a heat sink having a cooling water path through which cooling water is passed to cool the submount; the apparatus also including a mounting base on which the plurality of semiconductor laser modules are disposed side by side wherein the mounting base includes a cooling water supply pipe connected to one end of the cooling water path of the heat sink of each semiconductor laser module so as to supply cooling water and also includes a cooling water drain pipe connected to the other end of the cooling water path so as to drain the cooling water whereby the cooling water is supplied and drained in parallel to and from the respective heat sinks.

In this semiconductor laser apparatus, the cooling water path of each heat sink is preferably formed in the shape of a groove such that cooling water comes in direct contact with each submount.

### Brief Description of Drawings

Fig. 1 is a cross-sectional view of an embodiment of a semiconductor laser apparatus according to the present invention;
Fig. 2 is a cross-sectional view of another embodiment of a semiconductor laser apparatus according to the present invention;
Fig. 3 is a cross-sectional view of still another embodiment of a semiconductor laser apparatus according to the present invention, in which semiconductor laser arrays are vertically stacked;
Fig. 4 is a top view of still another embodiment of a semiconductor laser apparatus according to the present invention, in which semiconductor laser arrays are disposed side by side;
Fig. 5 is a side view of the apparatus shown in Fig. 4;
Fig. 6 is a cross-sectional view taken along line B-B of Fig. 4;
Fig. 7 is a top view illustrating a modification of the semiconductor laser apparatus according to the present invention;
Fig. 8 is a cross-sectional view illustrating another modification of the semiconductor laser apparatus according to the present invention;
Fig. 9 is a side view illustrating still another modification of the semiconductor laser apparatus according to the present invention;
Fig. 10 is a cross-sectional view of a conventional semiconductor laser apparatus;
Fig. 11 is a top view of a conventional semiconductor laser apparatus including a plurality of semiconductor laser modules disposed side by side; and
Fig. 12 is a cross-sectional view taken along line A-A of Fig. 11.

### Best Mode for Carrying Out the Invention

Embodiments of the present invention are described below.

### First Embodiment

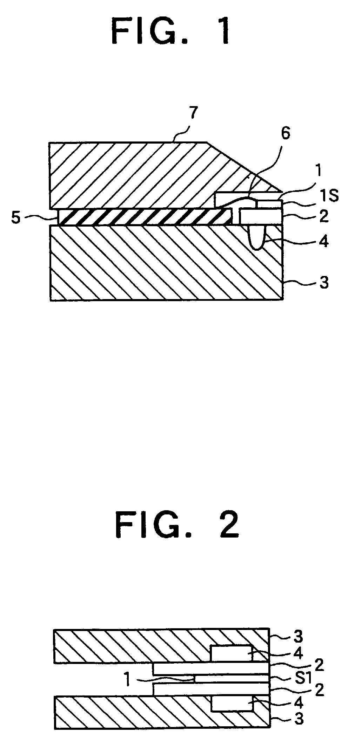

Fig. 1 is a cross-sectional view of an embodiment of a semiconductor laser apparatus according to the present invention.

Reference numeral 1 denotes a semiconductor laser array, 2 denotes a submount, 3 denotes a heat sink, 4 denotes a cooling water path formed in the heat sink, 7 denotes a cover for protecting the semiconductor laser array 1, 5 denotes an insulating plate for maintaining electric insulation between the heat sink 3 and the cover 7, and 6 denotes a lead wire for supplying an electric current to the semiconductor laser array 1. 1s denotes a laser emitting surface of the semiconductor laser array 1.

In this invention, the cooling water path 4 is formed into the shape of a groove on the top of the heat sink 3, immediately under the submount 2 so that cooling water (not shown) flowing through the cooling water path 4 comes in direct contact with the submount 2 thereby achieving a lower thermal resistance than can be obtained in the conventional cooling system in which heat is removed from the submount 2 via the heat sink 3, and thus reducing the increase in temperature of the semiconductor laser array 1.

The cooling water path 4 in the groove form not only provides an improvement in the cooling efficiency but it can be produced easier than producing a hole in a heat sink according to the conventional technique.

### Second Embodiment

Fig. 2 is a cross-sectional view of another embodiment of a semiconductor laser apparatus according to the present invention. Similar or equivalent parts to those in the above embodiment are denoted by similar reference numerals. Submounts 2 are bonded to both upper and lower surfaces of a semiconductor laser array 1. The respective submounts 2 are connected to different heat sinks 3 for cooling. The set of the upper submount 2 and the upper heat sink 3 is electrically isolated from the set of the lower submount 2 and the lower heat sink 3 so that a current can be supplied to the semiconductor laser array 3 via the upper and lower heat sinks 3.

In this embodiment, because the semiconductor laser array is cooled from both upper and lower sides, the cooling efficiency is improved and the semiconductor laser array is uniformly cooled and thus thermal strain due to the temperature difference between the upper and lower sides is reduced.

In the case where the apparatus shown in Fig. 2 is placed in a horizontal position, the semiconductor laser array is cooled from both left and right sides.

### Third Embodiment

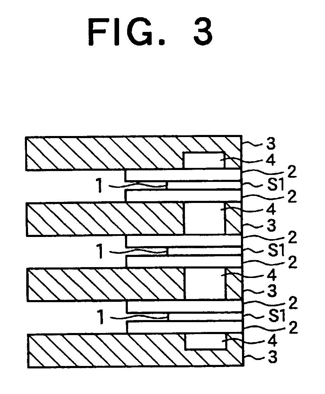

Fig. 3 is a cross-sectional view of still another embodiment of a semiconductor laser apparatus according to the present invention, in which semiconductor laser arrays are vertically stacked. Similar or equivalent parts to those in the above embodiments are denoted by similar reference numerals. Each semiconductor laser array 1 is sandwiched between upper and lower submounts 2 and each submount 2 is cooled by the corresponding heat sink 3 as shown in Fig. 2.

Heat sinks 3 other than the top and bottom ones serve to cool two submounts 2 located immediately above and below the respective heat sinks 3. The respective heat sinks 3 are electrically isolated from one another so that the semiconductor laser array 1 can be excited in series by applying a current between the top heat sink 3 and the bottom heat sink 3.

In the case where the apparatus shown in Fig. 3 is placed in a horizontal position, the semiconductor laser array is cooled from both left and right sides.

### Fourth Embodiment

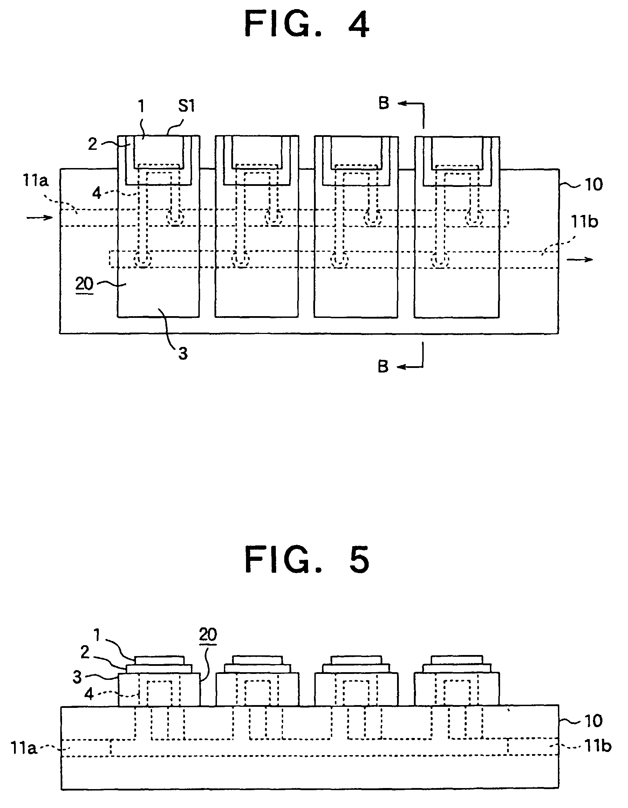

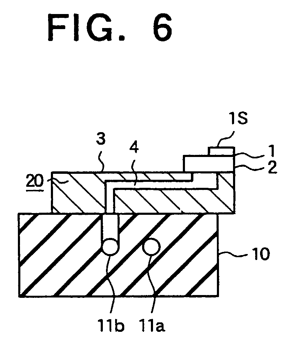

Figs. 4, 5 and 6 illustrate another embodiments of semiconductor laser apparatuses according to the present invention, in which semiconductor laser arrays are disposed side by side, wherein Figs. 4 and 5 are top and side views, respectively, and Fig. 6 is a cross-sectional view taken along line B-B of Fig. 4. Similar or equivalent parts to those in the above embodiments are denoted by similar reference numerals. Reference numeral 10 denotes a module mounting base on which a plurality of semiconductor laser modules 20 are mounted side by side. 11a and 11b denote a cooling water supply and drain pipes, respectively, formed in the mounting base. 4 denotes a cooling water path formed in the heat sink 3 wherein the cooling water path may be formed either in the shape of a groove such as that employed in the above embodiments or in a conventional pipe structure.

The cooling water path 4 is formed in the heat sink 3 of each semiconductor laser module 20. A water supply inlet and a water drain outlet are formed on the lower side of each heat sink, at respective two ends of the water cooling water path 4. The water supply inlet and the water drain outlet are formed at locations just above the cooling water supply pipe 11a and the cooling water drain pipe 11b, respectively, formed in the mounting base 10.

Cooling water is supplied from the cooling water supply pipe 11a formed in the mounting base 10, via a vertically extending pipe, into the cooling water path 4 of the heat sink 3 located under the semiconductor laser module 20. After removing, via the submount 2, heat generated by the semiconductor laser array 1, the cooling water is directly passed into the cooling water drain pipe 11b formed in the mounting base 10.

In this structure, the cooling water is supplied in parallel to the respective semiconductor laser modules 20 and thus the water pressure at the inlet of the cooling water path 4 of the heat sink 3 becomes equal for all modules. The cooling water path has a minimum cross-sectional area in the heat sink 3 of the semiconductor module 20 because the heat sink 3 does not have enough space for the cooling water path. Therefore, the pressure loss occurring in such a parallel cooling system is determined by the resistance of each semiconductor laser module.

This allows the pressure loss in the parallel cooling system to be minimized. As a result, it becomes possible to supply a larger amount of cooling water. Furthermore, because all semiconductor laser modules 20 are disposed in a parallel fashion, they are equally cooled and thus the variations in the output wavelength among the semiconductor lasers due to temperature differences are minimized.

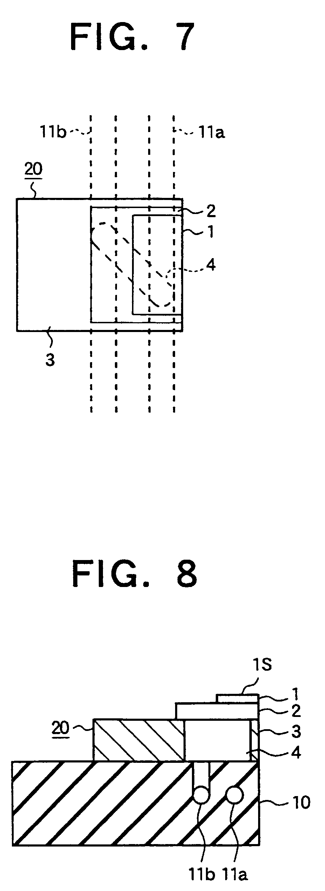

The cooling water supply pipe 11a and the cooling water drain pipe 11b may be formed in each mounting base 10 such that the both extend just below the submount 2. In this case, the cooling water path 4 may be formed in the heat sink 3 such that it extends between the cooling water supply pipe 11a and the cooling water drain pipe 11b as shown in Fig. 7. When it is desirable to more easily produce the cooling water path 4 in the heat sink 3, the cooling water path 4 may be produced simply by forming a rectangular-shaped hole as shown in Fig. 8. If such a structure is employed for the cooling water path in the heat sink, then it becomes much easier to produce the cooling water path than producing a pipe in the heat sink.

Although in the present embodiment, the module mounting base is disposed under the plurality of semiconductor laser modules, the module mounting base may be disposed on the back surface of the semiconductor laser modules.

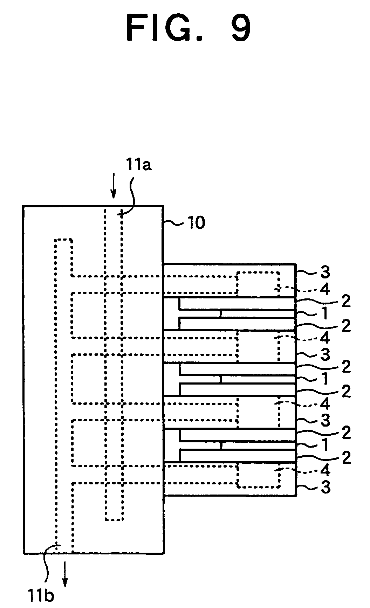

Furthermore, in the present embodiment, each semiconductor laser module includes one semiconductor laser array and cooling is performed from one side, the two-side cooling structure shown in Fig. 2 or the stacked structure shown in Fig. 3 may also be employed for the semiconductor laser modules. Fig. 9 illustrates an example in which a mounting base 10 including a cooling water supply pipe 11a and a cooling water drain pipe 11b is disposed on the back surface of a semiconductor laser apparatus with the same structure as that shown in Fig. 3.

That is, the embodiments described above may be combined in various manners. Thus, the present invention is not limited to the embodiments described above, and all possible combinations fall within the scope of the present invention.

### Industrial Applicability

According to the present invention, as described above, there is provided a semiconductor laser apparatus including a heat sink for cooling a semiconductor laser array using cooling water, in which a submount disposed immediately under the semiconductor laser array is directly cooled by the cooling water so as to reduce the thermal resistance between the semiconductor laser array and cooling water. In this structure, the thermal resistance between the heat sink and the submount is removed and thus the temperature difference between the semiconductor laser array and the cooling water is reduced. As a result, the change in wavelength with the output power is reduced and the upper limit of the output power can be increased.

The present invention also provides a semiconductor laser apparatus including a plurality of semiconductor laser modules each including a semiconductor laser array, a submount, and a heat sink, in which a mounting base is employed to supply cooling water in parallel to the heat sinks of the respective semiconductor laser modules. In this structure, the overall pressure loss of the cooling water is reduced and thus it becomes possible to supply a greater amount of water. Furthermore, it becomes possible to equally cool all semiconductor laser modules and thus the variations in the output wavelength are reduced.

## Claims

1. A semiconductor laser apparatus comprising:
a semiconductor laser array;
a plate-shaped submount having a coefficient of thermal expansion nearly equal to that of said semiconductor laser array and having high thermal conductivity; and
a heat sink having a cooling water path through which cooling water is passed such that the cooling water comes into direct contact with said submount thereby cooling said submount.

2. A semiconductor laser apparatus according to Claim 1, wherein said cooling water path of the heat sink is formed in the structure of a groove.

3. A semiconductor laser apparatus according to Claim 2, wherein said submount and heat sink are disposed at both sides of said semiconductor laser array so that said semiconductor laser array is cooled from both sides.

4. A semiconductor laser apparatus according to Claim 3, further comprising a mounting base on which laser arrays, submounts and heat sinks are mounted all together, wherein said mounting base includes a cooling water supply pipe connected to one end of the cooling water path of each heat sink so as to supply cooling water and also includes a cooling water drain pipe connected to the other end of the cooling water path so as to drain the cooling water whereby the cooling water is supplied and drained in parallel to and from the respective heat sinks.

5. A semiconductor laser apparatus according to Claim 1, wherein a plurality of said semiconductor laser arrays are disposed in a stacked fashion; two submounts are bonded to both sides, respectively, of each said semiconductor laser array; and there are provided heat sinks each having a cooling water path which is formed between respective adjacent submounts or on the outer surface of submounts located at both ends such that cooling water flowing through said cooling water path comes in direct contact with a submount located at one side or two submounts located at both sides.

6. A semiconductor laser apparatus according to Claim 5, further comprising a mounting base on which laser arrays, submounts and heat sinks are mounted all together, wherein said mounting base includes a cooling water supply pipe connected to one end of the cooling water path of each heat sink so as to supply cooling water and also includes a cooling water drain pipe connected to the other end of the cooling water path so as to drain the cooling water whereby the cooling water is supplied and drained in parallel to and from the respective heat sinks.

7. A semiconductor laser apparatus comprising:
a plurality of semiconductor laser modules each comprising: a semiconductor laser array; a plate-shaped submount having a coefficient of thermal expansion nearly equal to that of said semiconductor laser array and having high thermal conductivity; and a heat sink having a cooling water path through which cooling water is passed to cool said submount; and
a mounting base on which said plurality of semiconductor laser modules are disposed side by side wherein said mounting base includes a cooling water supply pipe connected to one end of the cooling water path of the heat sink of each semiconductor laser module so as to supply cooling water and also includes a cooling water drain pipe connected to the other end of the cooling water path so as to drain the cooling water whereby the cooling water is supplied and drained in parallel to and from the respective heat sinks.

8. A semiconductor laser apparatus according to Claim 7, wherein said cooling water path of each heat sink is formed in the shape of a groove such that cooling water comes in direct contact with each said submount.
